# EUROPEAN PATENT SPECIFICATION

(11) **EP 1 794 752 B1**
(45) Date of publication and mention of the grant of the patent: **10.11.2010**
(21) Application number: 05782801.4
(22) Date of filing: 14.09.2005
(51) Int. Cl.: G11B 20/00

(54) **METHOD OF GENERATING VERIFICATION DATA**
VERFAHREN ZUR GENERIERUNG VON PRÜFDATEN
PROCEDE DE GENERATION DE DONNEES DE VERIFICATION

(30) Priority: 22.09.2004 EP 04104579
(43) Date of publication of application: 13.06.2007
(73) Proprietor: Koninklijke Philips Electronics N.V., 5621 BA Eindhoven (NL)
(72) Inventor: DE HAAN, Wiebe, c/o Société Civile SPID, F-75008 Paris (FR)
(74) Representative: Groenendaal, Antonius W. M.
(86) International application number: PCT/IB2005/053007
(87) International publication number: WO 2006/033048

(56) References cited:
- US-A1- 2003 231 334

## Description

The invention relates to a method of generating verification data for verifying an authorisation level for a data stream.

The invention also relates to a circuit for generating verification data for verifying an authorisation level for a data stream.

The invention further relates to a computer programme product comprising computer executable instruction for enabling a computer to carry out such method.

The invention yet further relates to a record carrier for storing such computer programme product.

Furthermore, the invention relates to a programmed computer programmed to execute such a method.

An embodiment of such a method is known by the name of CPRM, an acronym of Content Protection for Record able Media (for more info http://www.theregister.co.uk/2001/01/10/ everything_you_ever_wanted/). CPRM is used in combination with a DVD Video Recording (DVD-VR) format on DVD-RAM and DVD-RW discs to protect recording of audiovisual content labelled as "copy once"

With the advent of broadband home internet connections and the abundance of digital storage possibilities, copying and distribution, content providers seek methods to prevent further distribution of audiovisual content. CPRM basically provides three levels of protection: copy freely, do not copy and copy restrictions not asserted. The latter option, which has been introduced later, enables that content can be freely copied, but may not be redistributed over the internet. In that case a so-called broadcast flag indicates that redistribution is prohibited.

A stream of audiovisual data, the data representing for example a film, is recorded as a sequence of VOBUs (Video Object Unit), each containing an RDI (Real-time Data Information) pack followed by a mix of audio, video and sub-picture packs. All packs have a size of 2048 bytes and a VOBU contains up to 1 second of audiovisual data. RDI packs are never encrypted. Bytes 128 up to byte 2047 of all others packs are encrypted. In byte 68 of an RDI pack, bits 7 and 6 comprise CGMS (Copy Generation Management System) data and bit 2 comprises EPN (Encryption Plus Non-assertion) data. Together they indicate the authorisation level for a user for copying the stream of audiovisual data, this information is provided in Table 1.

**Table 1**

| CGMS | EPN | DCI_CCI | Content status |
|---|---|---|---|
| | | Verification Data Verified? | |
| 00 | X | X | Copy freely |
| 11 | 0 | X | No more copies |
| 11 | 1 | No | No more copies |
| 11 | 1 | Yes | Protected using CPRM, but copy control restrictions not asserted |

Note that for the case that CGMS is set to 11 and EPN to 0, a hacker cannot simply toggle the EPN flag to 1 to make the content available for copying, as the DCI_CCI (Display Control Information/Copy Control Information) Verification data cannot be verified to be correct.

The Verification Data is a cryptographic function of:
64-bit DCI_CCI field in the RDI pack, byte 61-68
Title Key of the disc
Title Key Conversion Data of the pack following the RDI pack (bytes 85-91 of this pack) APSTB (Analogue protection System Trigger Bits; bits 5 and 4 of byte 68 of the RDI pack) in the RDI pack

The invention relies on the acknowledgement that the security measure of CPRM is not watertight. A hacker could apply the following procedure:
Make two protected (encrypted) recordings on a blank disc using CPRM, one that is "copy no more" and a second one for which copy restrictions are not asserted.

For each RDI pack in the copy restricted recording find RDI packs in the non-restricted recording with identical Title Key Conversion Data in the next pack and replace the DCI_CCI and the Verification Data bytes from the restricted recording by those from the non-restricted recording.

This hack works because:
The title key is identical for all recordings on the same disc;
identical title key conversion data is likely to be present in both recordings; and the 8-bytes DCI_CCI field is likely to contain identical information in both recordings or can be manipulated to do so. Most of the bits are fixed (5 of the 8 bytes are reserved, statues byte depending on recorder features). The DCI bits only have a minor or no impact on playback, especially if sources with identical aspects ratios are selected.

It is an object of the invention to provide a more robust way of protecting audiovisual data. To achieve this object, the invention provides in a first aspect a method of processing a data stream as claimed in claim 1.

In this way, the input data for creating verification data is different for both authorisation levels and verification data cannot be copied from a stream with the first authorisation level (e.g. do not copy) to a stream with the second authorisation level (copy restrictions not asserted), because the verification data cannot be correctly verified.

In a second aspect, the invention provides adevice for processing a data stream as claimed in claim 15.

In further aspects, the invention provides a computer programme product comprising computer executable instruction for enabling a computer to carry out such method as provided in the first aspect, a record carrier for storing such computer programme product,and a programmed computer programmed to execute such a method as provided in the first aspect.

The invention will now be further elucidated by means of drawings and a description of embodiments of the invention. In the drawings,
Figure 1 shows an embodiment of the apparatus according to the invention;
Figure 2 shows an embodiment of the storage device according to the invention;
Figure 3 shows a flowchart depicting an embodiment of the method according to the invention; and
Figure 4 shows an embodiment of the data carrier according to the invention and an embodiment of the programmed computer according to the invention.

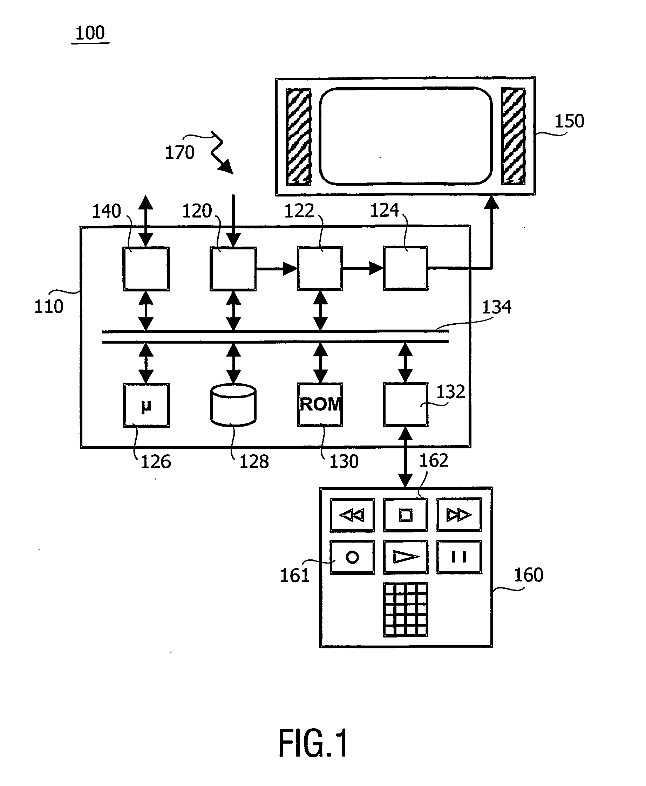

Figure 1 shows a consumer electronics system 100 comprising a video recorder 110 as an embodiment of the apparatus according to the invention, a TV-set 150 and a control device 160. The video recorder 110 is arranged to receive and record streams of audio-visual data and interactive applications associated with those streams of audio-visual data carried by a signal 170.

To this end, the video recorder 110 comprises a receiver 120 for receiving the signal 170, a de-multiplexer 122, a video processor 124, a central processing unit like a micro-processor 126 for controlling components comprised by the video recorder 110, a DVD recording drive 128 as a storage device, a programme code memory 130, a user command receiver 132 for receiving signal from the control device 160 and a central bus 134 for connecting components comprised by the video recorder 110.

The video recorder further comprises a network interface unit 140 for connecting to a network like the internet or a LAN. The network interface unit 140 may be embodied as an analogue modem, an ISDN, DSL or cable modem or a UTP/ethernet network interface.

The receiver 120 is arranged to tune in to a broadcast (audio or video) channel and derive data of that broadcast channel from the signal 170. The signal 170 can be received by any known method; cable, terrestrial; satellite, broadband network connection or any other method of distributing audiovisual data. The signal 170 can even be derived from the output of another consumer electronics apparatus. The receiver 120 outputs a base band signal that carries at least one stream of audiovisual data.

The de-multiplexer 122 is arranged to de-multiplex audiovisual data from other data that may be comprised in the base band signal outputted by the receiver 120.

The video processor 124 is arranged to render audiovisual data outputted by the de-multiplexer 122 in a way that is can be rendered by the TV-set 150. The output can be provided in various analogue formats as SECAM and PAL or digital formats.

Data stored in the programme code memory 130 enables the microprocessor 126 to execute the method according to the invention. The programme code memory 130 may be embodied as a Flash EEPROM, a ROM, an optical disk or any other type of data carrying medium.

The storage device may also be embodied as a hard disk drive and is adapted to store content that is received by either the receiver 120 or the network interface unit 140 for future reproduction on the TV-set 150 or for further dissemination via the network interface unit 140. The content may be processed prior to storage.

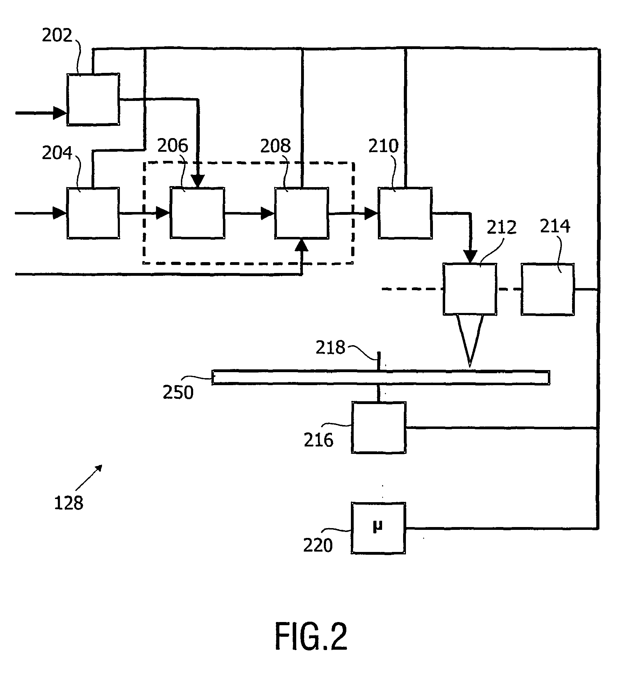

Figure 2 shows the DVD recording drive 128 in more detail. The DVD recording drive 128 comprises an audio compression circuit 202 as an embodiment of an audio encoding circuit, a video compression circuit 204 as an embodiment of a video encoding circuit, a multiplexer unit 206, an encryption unit 208, a channel coding unit 210, a laser unit 212 comprising a laser diode and a modulator for modulating a laser beam emitted by the laser diode, a servo motor 214 for moving the laser unit 212, a spindle motor 216 for spinning a spindle 218 for spinning an optical disk 250 and a microcontroller 220 for controlling all elements of the DVD recording drive 128.

When a user of the video recorder 110 wants to store a television programme or other audiovisual data on the optical disc 250, a DVD-RW disc in this embodiment, he or she pushes a record button 161 on the control device 150. Of course, a person skilled in the art will appreciate that the audiovisual content can also be stored on a DVD+RW disc or other write once or rewritable optical media. When the user has pushed the record button 161, the incoming data is recorded on the optical disc 250. The incoming data can be received by means of the network interface unit 140 or the receiver 120. In a further embodiment, data to be stored on the optical disc 250 is retrieved by a further storage device (not shown) comprised by the video recorder 110, like a hard disk.

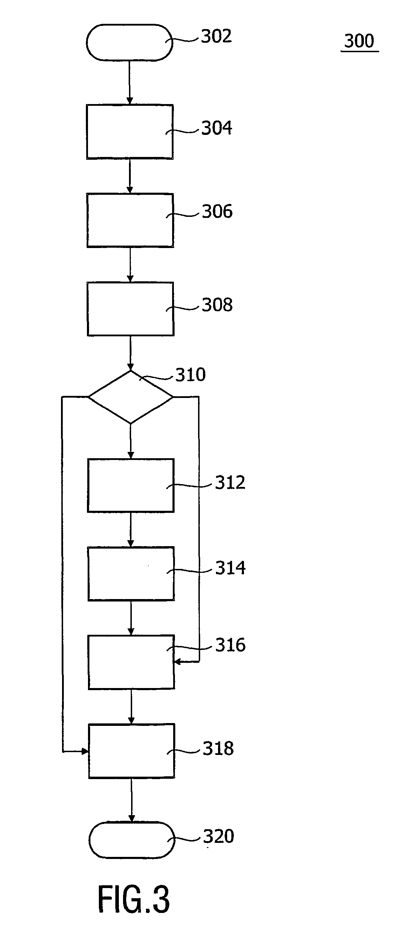

To record the content on the optical disc 250, a process depicted in Figure 3 by means of a flowchart 300 as an embodiment of the method according to the invention is executed. The process depicted by the flowchart 300 only shows process steps most important to illustrate the presented embodiment of the invention. As a person skilled in the art will readily appreciate, the reception and subsequent recording of a stream comprising audiovisual content comprises far more steps. As these steps can be found in literature known by a person skilled in the art, these steps have been omitted in the flowchart 300. Nevertheless, reference will be made to such steps, but they have been omitted for the sake of simplicity. A person skilled in the art will also understand that not all steps have to be executed in the order as depicted in the flowchart 300, but can also be executed in a different order.

Table 2 provides the text to go with the blocks in the flowchart 300.

| Block no. | Process |
|---|---|
| 302 | Receive recording command |
| 304 | Acquire stream to record |
| 306 | Format stream for recording |
| 308 | Set authorisation data in stream |
| 310 | Copy control level? |
| 312 | Modify data at title key conversion data location |
| 314 | Generate verification data |
| 316 | Encrypt |
| 318 | Record stream |
| 320 | Wait for stop record command |

The process is initiated in a process start step 302 by receiving a recording command. In a step 304, the stream to be recorded is acquired. As mentioned before, this acquisition is done by means of the receiver 120, the network interface unit 140 or by means of both.

Subsequently, the acquired stream is formatted for recording in a process step 306. The most important sub-steps for this are compression of audio and video data by the audio compression circuit 220 and the video compression circuit 204 and multiplexing of the compressed audio data and video data by the multiplexer unit 206. As a person skilled in the art will understand, extensive formatting the stream for recording will not always be necessary. When the data is to be stored as an MPEG programme stream and the acquired data is already formatted as an MPEG programme stream, most the formatting will be a redundant exercise, as the data is already in compressed and multiplexed form. However, a person skilled in the art is also aware that for recording of such a stream of audiovisual data on the optical disc 250, nevertheless additional formatting is necessary. An example for this is the insertion of additional data packs for navigation purposes (navpacks) and real-time data management (RDI-packs).

The output of the multiplexer 206 is a stream of data packs of 2048 bytes. These packs carry either audio data, video data, auxiliary data (navpacks, RDI packs) or custom data (additional audio data and the like). The packs comprise a pack header identifying the pack and the payload carried by the pack and the pack carries the payload, i.e. the actual data of the stream.

In more and more broadcasted material, especially in digital broadcast content, copy control data is embedded. This copy control data represents a copy control level, indicating privileges of a user/viewer on to what extent the user is allowed to re-record and/or re-distribute the recorded data. This data has to be set in the recorded stream as well, as it determines what is allowed to be done with the recorded stream. In a decision step 308, the copy control level of the stream is set in the data stream to be recorded. In this embodiment, this data is stored in an RDI pack, in bits 2 (encryption plus non-assertion flag), 6 and 7 (copy generation management system flag) of byte 68.

Subsequently, the process branches dependent on the value of the copyright control data. When the content in the stream to be recorded can be copied freely, independent of the medium, the process directly branches to a process step 318, in which the formatted data is recorded on the optical disc 250. In the process step 318, the data to be recorded is coded by channel coding unit 210 for enhancing error recovery possibilities and synchronisation. The output signal of the channel coding unit 210 is fed to the laser unit 212 to write the data on the optical disc 250. The location of the writing position is controlled by the servomotor 214 (distance from the centre of the disc) and the spindle motor 216.

The recording of the stream is ended in a terminator 320 when the disc is full, the user presses a stop button 162 on the control device 160 or, in case a specific end time (absolute or relative to the start time) has been reached, automatically.

When the received content is not allowed to be copied anymore once recorded on the optical disc 250 - authorisation level is 'do not copy' -, the process branches to a process step 316, in which the data is encrypted. In a preferred embodiment, the first 128 bytes of a data pack are not encrypted to enhance identification of the data pack. Subsequently, the encrypted data is recorded in the process step 318 and the process continues as already described.

When the recorded content is not allowed to be copied, but this copy restriction is not asserted, the process branches to a process step 312 in the decision step 310. Basically, this authorisation or copy control level means that a user is allowed to copy the data on another optical disc, but that the same user is not allowed to further re-distribute the data over for example the internet.

To prevent the last option from happening, the data is encrypted anyway, but authorisation data is set different. To prevent hacking by simply modifying the authorisation data, the authorisation level 'copy control restrictions not asserted' is only valid when also certain verification data is verified.

As already mentioned in the introduction of the description, it is desired to modify the authorisation level from 'do not copy' to 'copy control restrictions not asserted', which is not very difficult to do as mentioned in the introduction. Therefore, according to this embodiment of the invention, at least some data used for generating the verification data is modified in the process step 312.

For the DVD-VR video recording format with CPRM, the verification data is a cryptographic function of display control information and copy control information in the RDI pack in which the copy control information is stored, the title key (which is the same data for the whole disc), title key conversion data, in practise bytes 84 through 91 of the pack following the RDI pack and the analogue protection system trigger bits in the RDI pack. The verification data is stored in byte 2040 through 2047 of the RDI pack.

In this embodiment, because most of the data used to generate the verification data is already defined by other restriction, the only possible way to vary input data for the process of generating the verification data is to modify the title key conversion data. Most important is that the title key conversion data is different in a stream with authorisation level 'copy no more' compared to a stream with authorisation 'copy control restrictions not asserted'. The invention provides various embodiments for modifying the data or (re-) arranging the data stream to ensure this.

In the first embodiment, it is made sure that the first pack following the RDI pack is a pack comprising audio data. Depending on the audio coding method used, audio packs have usually more or less short headers followed by the actual coded audio data, guaranteeing random data at byte locations 84-91. This can be implemented in two ways. Independent of the authorisation level, an RDI pack is always followed by an audio pack. This is easy to implement as it is independent of the authorisation level and works because of the random character of audio. The second way is that whether or not an audio pack is put directly after the RDI pack depends on the authorisation level.

In the next embodiment, it is made sure that bytes 84-91 of the pack following an RDI pack comprise random data. The MPEG-2 video data after the pack and packet header in this pack usually start with a sequence header, sequence extension, sequence display extension, a GoP header (with or without line 21 data in the case of NTSC) and a picture header. It is allowed to insert stuffing in a video data pack. Stuffing in front of the sequence header is possible, but that generates just a few tens of variations. A better option is to store random data at byte location 84-91 by inserting user data immediately after the data for 'sequence_display_extension()'. When the sequence header contains quantiser matrices (for DCT compression, set by the video encoder 204), the title key conversion data is part of the quantiser matrix data, usually the same for each sequence in real-time encoders. There is no possibility to insert random data in this case. Therefore, a general solution for packs with video data is not available.

In a third embodiment, a user-defined pack is inserted after each RDI pack. User defined packs are currently not allowed by the DVD-VR specifications, but they could simply be defined in an amendment of the specification. User defined packs simply contain a pack header, a packet header for a private)stream_2 packet, a sub_stream_id indicating a user defined stream. Decoders will simply ignore such a stream. For the user-defined stream it will be required to contain a random number or a unique number at location 84-91.

In another embodiment, the position for the MPEG start code, for example the sequence header start code, is shifted depending on the authorization level. The MPEG-2 video specification allows insertion of stuffing bytes before the sequence header code (0x000001B3). In this way, the stream headers can be shifted to a location such that, depending on the amount of stuffing, unique values are guaranteed for the title key conversion data locations. This is especially the case when the stuffing is done such that one of the unique start codes are located in the title key conversion data bytes.

In yet a further embodiment, the RDI packs are followed by a user defined pack with stuffing as in the previous embodiment.

Various other embodiments are available to a person skilled in the art by combining the five embodiments so described.

As a person skilled in the art will readily understand, other embodiments of the invention are possible to implement, by which rather than data of the pack directly following the RDI pack, data in another pack succeeding the RDI pack or preceding the RDI pack is used for creating the verification data.

After the verification data has been generated, it is added at the end of the RDI pack. Subsequently, the data stream is encrypted in the process step 316 and the process continues as already discussed.

Although it has been proposed above that the stream is to be (re-) arranged (optionally including modification of the title key conversion data) when the authorisation level is "copy control restrictions not asserted", it will be appreciated that the invention can be embodied the other way around as well by re(-arranging) the stream when the authorisation level is "copy no more" and the stream is left as is when the authorisation level is "copy control restrictions not asserted". Most important is that the title key conversion data is different for both authorisation levels.

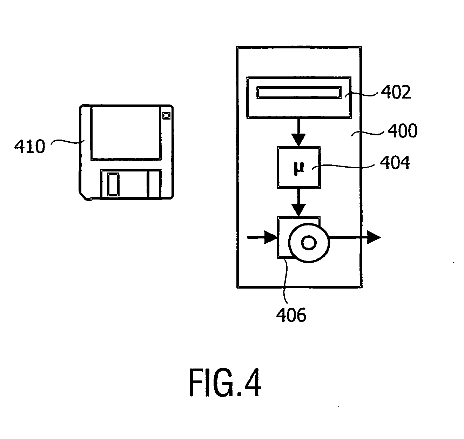

The method can also be carried out on a general-purpose computer like the personal computer 400 as shown in Figure 4. Figure 4 also shows a data carrier 410 comprising data to program the personal computer 400 to perform the method according to the invention. To this, the data carrier 410 is inserted in a disk drive 402 comprised by the personal computer 400. The disk drive 402 retrieves data from the data carrier 410 and transfers it to the microprocessor 404 to program the microprocessor 404. The programmed microprocessor 404 controls a media processor 406 to perform the method according to the invention when storing data on an optical disc in a disk drive 408.

It will be appreciated that "comprising" does not exclude other elements or steps, that "a" or "an" does not exclude a plurality, and that a single processor or other unit may fulfil the functions of several means recited in the claims. Although some elements have been described as performing one function, the invention can also be embodied with elements performing multiple functions to embody the method according to the invention. Also the other way around, where an embodiment of the invention has been described as multiple elements performing one function, the invention may also be embodied with one element performing that function. Also, any reference signs in the claims shall not be construed as limiting the scope.

In summary, the invention relates to the following: to prevent dissemination of content stored on a DVD-RW disc, CPRM is provided. However, this does not provide a watertight system. The invention proposes to arrange a stream to be recorded such that the input for verification data and therefore verification data is different for different authorisation levels. Various embodiments for implementing the invention are disclosed and comprise re-arranging data packs to be recorded and /or modifying data in data packets.

## Claims

1. Method of processing a data stream including generating verification data for verifying the integrity of an authorisation level for the data stream, wherein
the authorisation level can be set to at least a first value and a second value,
comprising:
- arranging the data stream such that in case of the authorization level having the first value, data at a pre-determined location is different from data at the pre-determined location in case of the authorization level having the second value; and
- generating the verification data using a cryptographic function of data from the stream at the pre-determined location, and
- embedding said verification data into said data stream for use during copy control.

2. Method as claimed in claim 1, wherein arranging the stream comprises:
modifying original data at a pre-determined location in the stream when the authorisation level has at least one pre-determined value.

3. Method as claimed in claim 2, wherein the modifying of original data comprises replacing the original data by newly generated data.

4. Method as claimed in claim 3, wherein the newly generated data is randomly generated.

5. Method as claimed in claim 2, wherein the modifying of the original data comprises inserting data prior to the original data, thus shifting the location of the original data in the data stream.

6. Method as claimed in any of the preceding claims, wherein the data stream comprises data packs and the pre-determined location is a pre-determined location in a pre-determined data pack.

7. Method as claimed in claim 6, wherein the verification data is comprised by a pack and the pre-determined pack is the pack preceded by the pack comprising the verification data.

8. Method as claimed in claim 6, wherein the pre-determined pack is a pack not comprised by the original data stream.

9. Method as claimed in any of the preceding claims, wherein the data stream comprises audio and video data.

10. Method as claimed in claim 9, wherein
a) the data stream comprises
i) data packs of a first type comprising audio data;
ii) data packs of a second type comprising video data; and
iii) data packs of a third type comprising the verification data; and
b) the pre-determined location is a pre-determined location in a pre-determined pack;
c) the arranging of the data stream comprises arranging the stream such that the pack succeeding the pack of the third type is a pack of the first type.

11. Method as claimed in any of the preceding claims, wherein the data stream is an MPEG2 data stream.

12. Method as claimed in any of the preceding claims, wherein the authorisation level can take at least one of the following values:
a) copying of the data stream is freely allowed;
b) copying of the data stream is not allowed; and
c) copying of the data stream is only allowed to a similar medium on which the data stream is stored.

13. Method as claimed in any of the preceding claims, coprising storing the data stream and the verification data embedded therein on a data carrier.

14. Method according to claim 13, wherein the data carrier is a DVD disc.

15. Device for processing a data stream including generating verification data for verifying the integrity of an authorisation level for the data stream, wherein
the authorisation level can be set to at least a first value and a second value,
comprising a processing unit conceived to:
- arrange the data stream such that in case of the authorization level having the first value, data at a pre-determined location is different from data at the pre-determined location in case of the authorization level having the second value; and
- generate the verification data using the cryptographic function of data from the stream at the pre-determined location, and
- embed said verification data into said data stream for use during copy control.

16. Computer programme product comprising computer executable instruction for enabling a computer to carry out the method according to claim 1.

17. Record carrier having stored thereon the computer programme product according to claim 16.

18. Programmed computer programmed to execute the method according to claim 1.

## Patentansprüche

1. Verfahren zum Verarbeiten eines Datenstroms, wobei dieses Verarbeiten das Erzeugen von Prüfdaten zum Überprüfen der Integrität eines Autorisierungspegels für den Datenstrom umfasst, wobei
der Autorisierungspegel auf wenigstens einen ersten Wert und einen zweiten Wert gesetzt werden kann,
wobei das Verfahren Folgendes umfasst:
- das Arrangieren des Datenstroms, und zwar derart, dass in dem Fall, dass der Autorisierungspegel den ersten Wert hat, Daten an einer vorbestimmten Stelle von Daten an der vorbestimmten Stelle abweichen, in dem fall, dass der Autorisierungspegel den zweiten Wert hat; und
- das Erzeugen der Prüfdaten unter Anwendung einer kryptographischen Funktion von Daten aus dem Strom an der vorbestimmten Stelle, und
- das Einbetten der genannten Prüfdaten in den genannten Datenstrom zur Verwendung während der Kopiersteuerung.

2. Verfahren nach Anspruch 1, wobei das Arrangieren des Stroms Folgendes umfasst:
das Modifizieren ursprünglicher Daten an einer vorbestimmten Stelle in dem Strom, wenn der Autorisierungspegel wenigstens einen vorbestimmten Wert hat.

3. Verfahren nach Anspruch 2, wobei das Modifizieren ursprünglicher Daten das Ersetzen der ursprünglichen Daten durch neu erzeugte Daten umfasst.

4. Verfahren nach Anspruch 3, wobei die neu erzeugten Daten beliebig erzeugt werden.

5. Verfahren nach Anspruch 2, wobei das Modifizieren der ursprünglichen Daten das Einfügen von Daten vor die ursprünglichen Daten umfasst, wodurch auf diese Art und Weise die Stelle der ursprünglichen Daten in dem Strom verschoben wird.

6. Verfahren nach einem der vorstehenden Ansprüche, wobei der Datenstrom Datenpakete umfasst und die vorbestimmte Stelle eine vorbestimmte Stelle in einem vorbestimmten Datenpaket ist.

7. Verfahren nach Anspruch 6, wobei die Prüfdaten sich in einem Paket befinden und das vorbestimmte Paket das Paket ist, dem das Paket mit den Prüfdaten vorhergeht.

8. Verfahren nach Anspruch 6, wobei das vorbestimmte Paket ein Paket ist, das sich nicht in dem ursprünglichen Datenstrom befindet.

9. Verfahren nach einem der vorstehenden Ansprüche, wobei der Datenstrom Audio- und Videodaten umfasst.

10. Verfahren nach Anspruch 9, wobei
a) der Datenstrom Folgendes umfasst:
i) Datenpakete eines ersten Typs mit Audiodaten;
ii) Datenpakete eines zweiten Typs mit Videodaten; und
iii) Datenpakete eines dritten Typs mit den Prüfdaten; und
b) die vorbestimmte Stelle eine vorbestimmte Stelle in einem vorbestimmten Paket ist;
c) das Arrangieren des Datenstroms das Arrangieren des Stromes umfasst, und zwar derart, dass das dem Packet des dritten Typs nachfolgende Paket ein Paket des ersten Typs ist.

11. Verfahren nach einem der vorstehenden Ansprüche, wobei der Datenstrom ein MPG2 Datenstrom ist.

12. Verfahren nach einem der vorstehenden Ansprüche, wobei der Autorisierungspegel wenigstens einen der nachfolgenden Werte annehmen kann:
a) das Kopieren des Datenstroms ist frei erlaubt;
b) das Kopieren des Datenstroms ist nicht erlaubt; und
c) das Kopieren des Datenstroms ist nur einem gleichen Medium erlaubt, auf dem der Datenstrom gespeichert ist.

13. Verfahren nach einem der vorstehenden Ansprüche, wobei das Verfahren das Speichern des Datenstroms und der darin eingebetteten Prüfdaten auf einem Träger umfasst.

14. Verfahren nach Anspruch 13, wobei der Datenträger eine DVD-Disk ist.

15. Anordnung zum Verarbeiten eines Datenstroms, wobei das Verarbeiten das Erzeugen von Prüfdaten zum Überprüfen der Integrität eines Autorisierungspegels für den Datenstrom umfasst, wobei
der Autorisierungspegel auf wenigstens einen ersten Wert und einen zweiten Wert gesetzt werden kann,
wobei die Anordnung eine Verarbeitungseinheit umfasst, vorgesehen zum:
- Arrangieren des Datenstroms, und zwar derart, dass in dem Fall, dass der Autorisierungspegel den ersten Wert hat, Daten an einer vorbestimmten Stelle von Daten an der vorbestimmten Stelle abweichen, in dem fall, dass der Autorisierungspegel den zweiten Wert hat; und
- Erzeugen der Prüfdaten unter Anwendung einer kryptographischen Funktion von Daten aus dem Strom an der vorbestimmten Stelle, und
- Einbetten der genannten Prüfdaten in den genannten Datenstrom zur Verwendung während der Kopiersteuerung.

16. Computerprogrammprodukt mit einer vom Computer durchführbaren Instruktion, damit ein Computer in den Stand gesetzt wird, das Verfahren nach Anspruch 1 durchzuführen.

17. Aufzeichnungsträger, auf dem das Computerprogrammprodukt nach Anspruch 16 gespeichert ist.

18. Programmierter Computer, programmiert zum Durchführen des Verfahrens nach Anspruch 1.

## Revendications

1. Procédé de traitement d'un flux de données comprenant la génération de données de vérification pour vérifier l'intégrité d'un niveau d'autorisation pour le flux de données, dans lequel :
le niveau d'autorisation peut être réglé à au moins une première valeur et une deuxième valeur,
comprenant les étapes suivantes consistant à :
- arranger le flux de données tellement que, dans le cas du niveau d'autorisation ayant la première valeur, des données à un emplacement prédéterminé sont différentes de données à l'emplacement prédéterminé dans le cas du niveau d'autorisation ayant la deuxième valeur ; et
- générer les données de vérification en utilisant une fonction cryptographique de données en provenance du flux à l'emplacement prédéterminé, et
- intégrer lesdites données de vérification dans ledit flux de données pour être utilisées lors du contrôle de copie.

2. Procédé selon la revendication 1, dans lequel l'arrangement du flux comprend :
la modification de données originales à un emplacement prédéterminé dans le flux lorsque le niveau d'autorisation présente au moins une valeur prédéterminée.

3. Procédé selon la revendication 2, dans lequel la modification de données originales comprend le remplacement des données originales par des données récemment générées.

4. Procédé selon la revendication 3, dans lequel les données récemment générées sont générées aléatoirement.

5. Procédé selon la revendication 2, dans lequel la modification des données originales comprend l'insertion de données avant les données originales, ainsi décalant l'emplacement des données originales dans le flux de données.

6. Procédé selon l'une quelconque des revendications précédentes 1 à 5, dans lequel le flux de données comprend des paquets de données et dans lequel l'emplacement prédéterminé est un emplacement prédéterminé dans un paquet de données prédéterminé.

7. Procédé selon la revendication 6, dans lequel les données de vérification sont renfermées par un paquet et dans lequel le paquet prédéterminé est le paquet qui est précédé du paquet comprenant les données de vérification.

8. Procédé selon la revendication 6, dans lequel le paquet prédéterminé est un paquet qui n'est pas renfermé par le flux de données originales.

9. Procédé selon l'une quelconque des revendications précédentes 1 à 8, dans lequel le flux de données comprend des données audio et vidéo.

10. Procédé selon la revendication 9, dans lequel :
a) le flux de données comprend :
i) des paquets de données d'un premier type comprenant des données audio ;
ii) des paquets de données d'un deuxième type comprenant des données vidéo ; et
iii) des paquets de données d'un troisième type comprenant les données de vérification ; et
b) l'emplacement prédéterminé est un emplacement prédéterminé dans un paquet prédéterminé ;
c) l'arrangement du flux de données comprend l'arrangement du flux de telle façon que le paquet qui succède le paquet du troisième type soit un paquet du premier type.

11. Procédé selon l'une quelconque des revendications précédentes 1 à 10, dans lequel le flux de données est un flux de données MPEG2.

12. Procédé selon l'une quelconque des revendications précédentes 1 à 11, dans lequel le niveau d'autorisation peut adopter au moins une des valeurs suivantes :
a) la duplication du flux de données est librement autorisée ;
b) la duplication du flux de données n'est pas autorisée ; et
c) la duplication du flux de données est seulement autorisée sur un support similaire sur lequel le flux de données est stocké.

13. Procédé selon l'une quelconque des revendications précédentes 1 à 12, comprenant le stockage du flux de données et la vérification des données qui y sont intégrées sur un support de données.

14. Procédé selon la revendication 13, dans lequel le support de données est un vidéodisque numérique.

15. Dispositif de traitement d'un flux de données comprenant la génération de données de vérification pour vérifier l'intégrité d'un niveau d'autorisation pour le flux de données, dans lequel :
le niveau d'autorisation peut être réglé à au moins une première valeur et une deuxième valeur,
comprenant une unité de traitement qui est conçue de manière à :
- arranger le flux de données tellement que, dans le cas du niveau d'autorisation ayant la première valeur, des données à un emplacement prédéterminé sont différentes de données à l'emplacement prédéterminé dans le cas du niveau d'autorisation ayant la deuxième valeur ; et
- générer les données de vérification en utilisant une fonction cryptographique de données en provenance du flux à l'emplacement prédéterminé, et
- intégrer lesdites données de vérification dans ledit flux de données pour être utilisées lors du contrôle de copie.

16. Produit de programme informatique comprenant une instruction exécutable par l'ordinateur pour permettre à un ordinateur de mettre en oeuvre le procédé selon la revendication 1.

17. Support d'enregistrement sur lequel est stocké le produit de programme informatique selon la revendication 16.

18. Ordinateur programmé qui est programmé pour mettre en oeuvre le procédé selon la revendication 1.
